# EUROPÄISCHE PATENTSCHRIFT

(11) **EP 3 411 735 B1**
(45) Veröffentlichungstag und Bekanntmachung des Hinweises auf die Patenterteilung: **19.11.2025**
(21) Anmeldenummer: 17702360.3
(22) Anmeldetag: 30.01.2017
(51) Int. Cl.: G02B 5/08, G02B 5/09, G03F 7/20, G03F 7/00

(54) **VERFAHREN ZUR HERSTELLUNG EINES REFLEKTIVEN OPTISCHEN ELEMENTS UND REFLEKTIVES OPTISCHES ELEMENT**
METHOD FOR PRODUCING A REFLECTIVE OPTICAL ELEMENT AND REFLECTIVE OPTICAL ELEMENT
PROCÉDÉ DE FABRICATION D'UN ÉLÉMENT OPTIQUE RÉFLÉCHISSANT ET ÉLÉMENT OPTIQUE RÉFLÉCHISSANT

(30) Priorität: 02.02.2016 DE 102016201564
(43) Veröffentlichungstag der Anmeldung: 12.12.2018
(73) Patentinhaber: Carl Zeiss SMT GmbH, 73447 Oberkochen (DE)
(72) Erfinder: ENKISCH, Hartmut, 73431 Aalen (DE)
(74) Vertreter: Werner & ten Brink
(86) Internationale Anmeldenummer: PCT/EP2017/051961
(87) Internationale Veröffentlichungsnummer: WO 2017/134020

(56) Entgegenhaltungen:
- EP-A1- 2 319 951
- WO-A1-2015/001805
- DE-A1- 102010 041 502
- DE-A1- 102011 005 144
- DE-A1- 102011 077 234
- DE-A1- 102012 205 615
- DE-A1- 102012 213 937
- US-A1- 2008 165 415
- US-A1- 2015 219 997

## Beschreibung

Die vorliegende Erfindung bezieht sich auf ein Verfahren zur Herstellung eines aus mindestens zwei Obereinheiten zusammengesetzten reflektiven optischen Elements für den extrem ultravioletten Wellenlängenbereich (etwa 1 nm bis 20 nm), wobei jede Obereinheit eine Vielzahl von Untereinheiten aufweist, sowie auf ein reflektives optischen Element für den extrem ultravioletten Wellenlängenbereich, zusammengesetzt aus mindestens zwei Obereinheiten, wobei jede Obereinheit eine Vielzahl von Untereinheiten aufweist. Ferner bezieht sie sich auf ein optisches Element sowie eine EUV-Lithographievorrichtung mit einem solchen reflektiven optischen Element.

Aus der DE 10 2012 213 937 A1 ist ein Spiegel-Array zum Einsatz im Beleuchtungssystem einer EUV-Lithographievorrichtung bekannt. Dieses Spiegelarray ist aus mehreren Unterarrays zusammengesetzt, die ihrerseits eine Vielzahl von Einzelspiegeln aufweisen. Um eine vereinfachte Wartung der Beleuchtungsoptik zu ermöglichen, ist vorgesehen, alle Einzelspiegel aller Unterarrays mit einer reflektiven Beschichtung zu versehen, die so breitbandig ausgelegt ist, dass sie alle Einfallswinkel abdeckt, die im Betrieb des Spiegelarrays an den verschiedenen Unterarrays auftreten können. Insbesondere handelt es sich um ein Mikrospiegelarray, das als mikroelektromechanische Systeme ausgebildet ist.

Die DE 10 2011 077 234 A1 beschreibt eine EUV-Spiegelanordnung mit einer Vielzahl von nebeneinander angeordneten Spiegelelementen, bei der die Reflektivität über eine piezoelektrische Schicht durch Dickenänderung beeinflusst werden kann.

Aus der US 2008/0165415 A1 ist bekannt, bei einem optischen System, insbesondere für die EUV-Lithographie, Spiegel mit unterschiedlichen reflektierenden Spiegelbeschichtungen vorzusehen, nämlich mit Viellagensystemen mit unterschiedlichen variierenden Lagendicken.

Es ist eine Aufgabe der vorliegenden Erfindung, Spiegelarrays insbesondere für die EUV-Lithographie dahingehend zu verbessern, dass ihre Reflektivität erhöht wird.

In einem ersten Aspekt wird diese Aufgabe gelöst durch ein Verfahren zur Herstellung eines aus mindestens zwei Obereinheiten zusammengesetzten reflektiven optischen Elements für den extrem ultravioletten Wellenlängenbereich, wobei jede Obereinheit eine Vielzahl von Untereinheiten aufweist, mit den Schritten:
- Aufteilen der Obereinheiten in Bandbreitenklassen mit für die jeweilige Bandbreitenklasse bestimmte maximale Bandbreite;
- Aufbringen einer reflektiven Beschichtung auf jeder Obereinheit, die an die jeweils über ihre Fläche bestimmten Einfallswinkel und Einfallswinkelbandbreiten angepasst ist, wobei auf alle Obereinheiten als reflektive Beschichtung ein Viellagensystem mit Periodenlänge aufgebracht wird, dessen Lagenabfolge und/oder Lagendicken an die für die jeweilige Bandbreitenklasse bestimmte maximale Bandbreite angepasst ist, wobei Basisviellagensysteme für jede Bandbreitenklasse unterschiedlich und angepasst an die benötigte Bandbreite ausgewählt werden, und wobei die gewünschte

Periodenlänge für jede Obereinheit einzeln in Abhängigkeit der im Betrieb auftretenden Einfallswinkel optimiert wird, indem für jede Obereinheit innerhalb einer Bandbreitenklasse die Periodenlänge des Basisviellagensystems um einen Faktor modifiziert wird.

Dieses Herstellungsverfahren hat den Vorteil, dass einerseits durch Anpassen der reflektiven Beschichtung auf jeder Obereinheit an die dort im Betrieb auftretenden Einfallswinkel und Einfallswinkelbandbreiten die Reflektivität erhöht werden kann. Andererseits bleibt der Aufwand bei der Herstellung des reflektiven optischen Elements und anschließend auch dessen Wartung relativ begrenzt, da insbesondere die Optimierung auf die Einfallswinkelbandbreiten auf die Obereinheiten beschränkt werden kann. Insbesondere bei EUV-Lithographievorrichtungen sind mehrere reflektive optische Elemente hintereinander angeordnet. Daher ist die Gesamtreflektivität innerhalb von EUV-Lithographievorrichtungen nicht sehr hoch und sind jegliche Reflektivitätsgewinne von Vorteil.

Es wird für jede Obereinheit die maximale Bandbreite der Einfallswinkel bestimmt. Daraufhin werden die Obereinheiten in Bandbreitenklassen eingeteilt und wird auf jede Obereinheit als reflektive Beschichtung jeweils ein Viellagensystem aufgebracht, dessen Lagenabfolge und/ oder Lagendicken an die für die jeweilige Bandbreitenklasse bestimmte maximale Bandbreite angepasst ist. Dadurch kann eine höhere Reflektivität des reflektiven optischen Elements erreicht werden. Besonders bevorzugt ist diese Vorgehensweise bei mehr als zwei Obereinheiten. Für jede Klasse wird ein Basisviellagenssystem festgelegt. Einfluss auf die Winkelbandbreite eines Viellagensystems kann beispielsweise über Lagenabfolgen erreicht werden, die Aperiodizitäten aufweisen oder über Lagendickengradienten senkrecht zum Substrat. Vorteilhafterweise ist das jeweilige Basisviellagensystem auf die Bandbreite der Obereinheit mit der größten Einfallswinkelbandbreite innerhalb einer Klasse ausgelegt.

Bei den Viellagensystemen handelt es sich bei dieser und auch den folgenden Ausführungsformen bevorzugt um Viellagensysteme aus alternierend angeordneten Lagen eines Materials mit einem geringeren Realteil des Brechungsindex im extrem ultravioletten Wellenlängenbereich und eines Materials mit einem höheren Realteil des Brechungsindex im extrem ultravioletten Wellenlängenbereich, insbesondere bei der Arbeitswellenlänge, bei der der lithographische Prozess durchgeführt wird, auf einem Substrat. Dabei können die alternierend angeordneten Lagen zu Perioden einer gewissen Länge zusammengefasst werden. Diese Viellagensysteme eignen sich besonderes für den extrem ultravioletten Wellenlängenbereich und lassen sich bekanntermaßen sehr flexibel durch die Wahl der Materialien, der Lagenabfolge und der Dickenverhältnisse für gewünschte mittlere Einfallswinkel und Einfallswinkelbandbreiten bei einer gewählten Wellenlänge ausbilden. Insbesondere kann bei einer bestimmten Lagenabfolge durch eine Änderung der Lagendicken um einen konstanten Faktor der Einfallswinkel, bei dem bei einer gewählten Wellenlänge die höchste Reflektivität erreicht wird, verschoben werden.

Besonders bevorzugt wird jede Obereinheit in Flächeneinheiten aufgeteilt und werden für jede Obereinheit über alle ihre Flächeneinheiten die im Betrieb auftretenden Einfallswinkel bestimmt. Daraufhin wird in Abhängigkeit der bestimmten Einfallswinkel eine gewünschte Periodenlänge eines Viellagensystems ermittelt und wird die Variation der gewünschten Periodenlänge über die Flächeneinheiten für jede Obereinheit durch ein Polynom n-ten Grades angenähert, wobei n eine nicht-negative ganze Zahl ist. Anschließend wird auf jede Obereinheit das entsprechende Viellagensystem als reflektive Beschichtung aufgebracht.

In einfachsten Varianten wird für jede Obereinheit eine konstante gewünschte Periodenlänge ermittelt, was einem Polynom 0-ten Grades entspricht. Ansätze, um je nach bestimmten im Betrieb auftreffenden Einfallswinkeln gewünschte Periodenlängen zu ermitteln, sind vielfach bekannt. Beispielsweise aus der DE 2013 203 364 A1 sind unterschiedliche Herangehensweisen bekannt, um aus einem maximalen und einem minimalen Einfallswinkel eine gewünschte Periodenlänge zu ermitteln. U.a. auf diese Weise können die reflektiven Beschichtungen für alle Obereinheiten grundsätzlich in einer einzigen Beschichtungscharge hergestellt werden, wobei mittels eines Peiodenlängenverlaufs über den Beschichtungshalter in der Beschichtungsanlage unterschiedliche Lagendicken für die einzelne zu beschichtende Obereinheit eingestellt werden können.

In weiteren Varianten kann der Verlauf der gewünschten Periodenlängen über die jeweilige Obereinheit durch Polynome ersten Grades, also durch lineare Funktionen angenähert werden. Auch so gestaltete Obereinheiten können zu Chargen zusammengefasst und in einem Prozess beschichtet werden. Je höher der Grad des Polynoms ist, mit dem der Verlauf der gewünschten Periodenlänge angenähert wird, desto geringer ist die Abweichung des aufgebrachten Periodenlängenverlaufs vom idealen Periodenlängenverlauf. Damit steigt die Reflektivität der Obereinheiten und des daraus zusammengesetzten reflektiven optischen Elements. Eine hinreichende Dickenkontrolle über die Fläche kann bei der Beschichtung beispielsweise durch Verwendung von Wabenmasken erreicht werden. Bei komplexeren Dickenverläufen kann auch ein Beschichtungsverfahren wie in der DE 10 2012 205 615 A1 beschrieben eingesetzt werden, bei dem schichtbildende Teilchen ionisiert und durch elektrische und/oder magnetische Felder zielgerichtet auf der zu beschichtenden Fläche aufgebracht werden. Alternativ oder auch zusätzlich können die Untereinheiten unterschiedlich zur Beschichtungsquelle orientiert werden, um auch dadurch die aufgebrachten Lagendicken zu beeinflussen. Über diese Ausführungsform lassen sich reflektive optische Elemente herstellen, deren Gesamtreflektivität besonders hoch ist.

Es sei darauf hingewiesen, dass der Verlauf der gewünschten Periodenlänge eindimensional in einer Richtung in der Fläche oder auch zweidimensional über die Fläche der Obereinheiten angenähert werden kann.

Von besonderem Vorteil ist es, wenn die Flächeneinheiten den Untereinheiten der Obereinheiten entsprechen. Dazu kann eine Flächeneinheit identisch mit der Fläche einer Untereinheit sein. Je nach Anzahl der Untereinheiten kann es aber auch sinnvoll sein, mehrere benachbarte Untereinheiten zu Flächeneinheiten zusammenzufassen, insbesondere, wenn die Verteilung der Einfallswinkel bzw. die Einfallswinkelbandbreite über diese Untereinheiten vergleichbar ist.

Vorteilhafterweise wird auf die Obereinheiten eine reflektive Beschichtung aufgebracht, indem die Obereinheiten auf einen um eine Achse rotierenden Beschichtungshalter aufgebracht werden, wobei Gebiete konstanter Lagendicken konzentrisch um die Achse angeordnet sind. Je nach erforderlichen Lagendicken bzw. Periodenlängen können die Obereinheiten in verschiedenen Abständen zur Rotationsachse des Beschichtungshalters angeordnet werden, um Obereinheiten mit unterschiedlich an im Betrieb auftretenden Einfallswinkel und Einfallswinkelbandbreite angepassten reflektiven Beschichtungen in gemeinsamen Chargen beschichten zu können.

In einem weiteren Aspekt wird die Aufgabe gelöst durch ein reflektives optisches Element für den extrem ultravioletten Wellenlängenbereich, hergestellt wie zuvor beschrieben, welches Obereinheiten aus mindestens zwei Bandbreitenklassen umfasst, wobei eine Bandbreitenklasse mindestens zwei Obereinheiten umfasst.

Derartige zusammengesetzte reflektive optische Elemente weisen eine höhere Reflektivität als die aus dem Stand der Technik bekannten, sind aber dennoch mit nicht zu hohem Aufwand herstellbar.

Hierbei weist jede Obereinheit des reflektiven optischen Elements ein an die im Betrieb bei genau dieser Obereinheit auftretenden Einfallswinkel angepasstes Viellagensystem auf. In Bezug auf die Einfallswinkelbandbreite weisen jeweils mindestens zwei Obereinheiten Viellagensysteme auf, die an die gleiche Einfallswinkelbandbreite angepasst sind. Insbesondere können die Viellagensysteme Aperiodizitäten oder Dickengradienten senkrecht zur Viellagensystemfläche aufweisen.

In bevorzugten Ausführungsformen sind die reflektiven Beschichtungen als Viellagensysteme ausgebildet, deren Lagendicken mit einer Funktion variiert, die jeweils einem Polynom n-ten Grades mit n einer nicht-negativen ganzen Zahl entspricht. Es kann sich dabei um ein eindimensionales oder ein zweidimensionales Polynom über die Fläche des Viellagensystems 0-ten, 1-ten, 2-ten, 3-ten, 4-ten oder eines beliebigen höheren Grades handeln.

Bevorzugt ist jede Untereinheit als einzeln aktuierbarer Spiegel ausgebildet. Ganz besonders bevorzugt ist jede Obereinheit als mikroelektronisches System von Mikrospiegeln ausgebildet. Dadurch lässt sich das reflektive optische Element besonders gut in optischen Systemen oder in EUV-Lithographievorrichtungen an Stellen einsetzten, an denen großflächigere Elemente benötigt werden, die über die gesamte Fläche gleichzeitig unterschiedlich und präzise ausgerichtet werden müssen.

Bevorzugt ist das reflektive optische Element als Feldfacettenspiegel ausgebildet.

Insbesondere reflektive optische Elemente auf der Basis von mikroelektromechanischen Systemen aus Mikrospiegeln wie etwa Spiegel-Arrays sind geeignet, als Feldfacettenspiegel eingesetzt zu werden. Die Kippung der einzelnen aktuierbaren Mikrospiegel wird im Betrieb so eingestellt, dass sowohl die Kippung einer Feldfacette als auch ihre Krümmung emuliert wird. Dabei trägt jede Obereinheit beispielsweise als Unterarray zu mehreren Feldfacetten bei und wird jede Feldfacette aus Abschnitten mehrerer Obereinheiten gebildet. Jede Feldfacette weist einen individuellen mittleren Einfallswinkel auf und eine individuelle Bandbreite von Einfallswinkeln. Das hier beschriebenen reflektive optische Element eignet sich besonders gut, um durch Berücksichtigung der Verteilung der Einfallswinkel über den Feldfacettenspiegel eine gute Reflektivität zur Verfügung zu stellen. Das hier vorgestellte reflektive optische Element kann auch als Pupillenfacettenspiegel ausgebildet sein.

In weiteren Aspekten wird die Aufgabe gelöst durch ein optisches System, insbesondere für die EUV-Lithographie, bzw. durch eine EUV-Lithographievorrichtung mit einem reflektiven optischen Element wie zuvor beschrieben.

Die vorliegende Erfindung soll unter Bezugnahme auf bevorzugte Ausführungsbeispiele näher erläutert werden. Dazu zeigen
- Figur 1: eine schematische Ansicht einer Ausführungsform einer EUV-Lithographievorrichtung;
- Figur 2: eine schematische Ansicht einer Ausführungsform eines Beleuchtungssystems;
- Figur 3: eine schematische Ansicht einer Ausführungsform eines reflektiven optischen Elements mit sieben Obereinheiten;
- Figur 4: eine schematische Ansicht einer Obereinheit;
- Figur 5: eine Prinzipskizze eines Viellagensystems;
- Figur 6: die Verteilung von Einfallswinkeln über die Fläche eines reflektiven optischen Elements mit fünf Obereinheiten;
- Figur 7: die reflektive Beschichtung eines herkömmlichen reflektiven optischen Elements mit fünf Obereinheiten;
- Figur 8: die reflektive Beschichtung einer ersten Ausführungsform eines erfindungsgemäßen reflektiven optischen Elements mit fünf Obereinheiten;
- Figur 9: die Reflektivität in Abhängigkeit vom Einfallswinkel für zwei verschiedene Viellagesysteme;
- Figur 10: die reflektive Beschichtung einer zweiten Ausführungsform eines erfindungsgemäßen reflektiven optischen Elements mit fünf Obereinheiten;
- Figuren 11, 12: zwei weitere schematische Ansichten des reflektiven optischen Elements aus Figur 3;
- Figur 13: eine Möglichkeit der Anordnung von zu beschichtenden Obereinheiten in einer Beschichtungsanlage;
- Figur 14: die reflektive Beschichtung einer dritten Ausführungsform eines erfindungsgemäßen reflektiven optischen Elements mit fünf Obereinheiten;
- Figur 15: die reflektive Beschichtung einer vierten Ausführungsform eines erfindungsgemäßen reflektiven optischen Elements mit fünf Obereinheiten;
- Figur 16: die mittlere Reflektivität bei mittleren Einfallswinkeln für die optischen reflektiven Elemente aus den Figuren 10 bis 14;
- Figur 17: die mittlere Reflektivität bei extremalen Einfallswinkeln für die optischen reflektiven Elemente aus den Figuren 10 bis 14;
- Figur 18: der mittlere PV-Wert bei mittleren Einfallswinkeln für die optischen reflektiven Elemente aus den Figuren 10 bis 14; und
- Figur 19: der mittlere PV-Wert bei extremalen Einfallswinkeln für die optischen reflektiven Elemente aus den Figuren 10 bis 14.

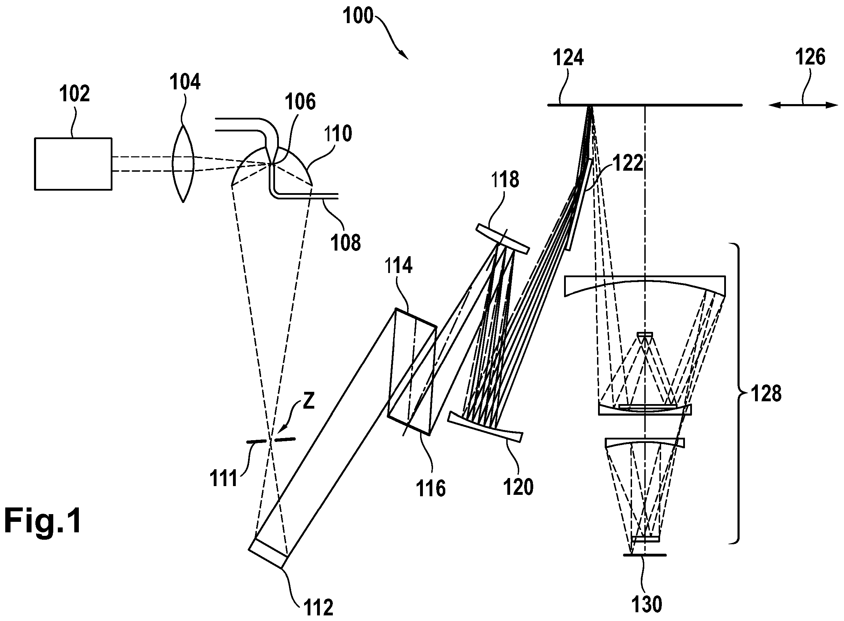

In Figur 1 ist in einer Prinzipansicht eine Projektionsbelichtungsanlage 100 für die Herstellung von beispielsweise mikroelektronischen Bauteilen gezeigt, die in einem Scanmodus entlang einer Scanrichtung 126 mit einer Arbeitswellenlänge im EUV-Bereich betrieben wird und die ein oder mehrere optische Elemente mit zusätzlicher Beschichtung aufweisen kann. Die in Figur 1 gezeigte Projektionsbelichtungsanlage 100 weist eine punktförmige Plasmastrahlungsquelle auf. Die Strahlung der Laserquelle 102 wird über eine Kondensorlinse 104 auf geeignetes Material gerichtet, das über die Zufuhr 108 eingeleitet wird und zu einem Plasma 106 angeregt wird. Die vom Plasma 106 emittierte Strahlung wird vom Kollektorspiegel 110 auf den Zwischenfokus Z abgebildet. Durch entsprechende Blenden 111 am Zwischenfokus Z wird gewährleistet, dass keine unerwünschte Streustrahlung auf die nachfolgenden Spiegel 112, 114, 116, 118, 120 des Beleuchtungssystems der Projektionsbelichtungsanlage 100 trifft. Der Planspiegel 122 dient zur Faltung des Systems, um Bauräume für mechanische und elektronische Komponenten in der Objektebene, in der die Halterung für das Retikel 124 angeordnet ist, zur Verfügung zu stellen. Im Beleuchtungssystem folgen im vorliegenden Beispiel auf den Spiegel 112 ein Feldfacettenspiegel 114 und ein Pupillenfacettenspiegel 116. Der Feldfacettenspiegel 114 dient dazu, eine Vielzahl von Abbildern der Strahlungsquelle der Projektionsbelichtungsanlage in eine Pupillenebene zu projizieren, in der ein zweiter Facettenspiegel angeordnet ist, der als Pupillenfacettenspiegel 116 dient und die Abbilder der Facetten des Feldfacettenspiegels 114 in der Objektebene überlagert, um eine möglichst homogene Ausleuchtung zu ermöglichen. Die anschließend an die Facettenspiegel 114, 116 angeordneten Spiegel 118 und 120 dienen im Wesentlichen dazu, das Feld in der Objektebene zu formen. In der Objektebene ist ein strukturiertes Retikel 124 angeordnet, dessen Struktur mittels eines Projektionsobjektivs 128 mit im vorliegenden Beispiel sechs Spiegeln auf das zu belichtende Objekt 130, etwa einen Wafer abgebildet wird. Das Retikel 124 ist in der hier als Scanning-System ausgelegten Projektionsbelichtungsanlage 100 in die eingezeichnete Richtung 126 verfahrbar und wird sukzessive abschnittsweise ausgeleuchtet, um die jeweiligen Strukturen des Retikels 124 mit dem Projektionsobjektiv entsprechend auf beispielsweise einen Wafer 130 zu projizieren.

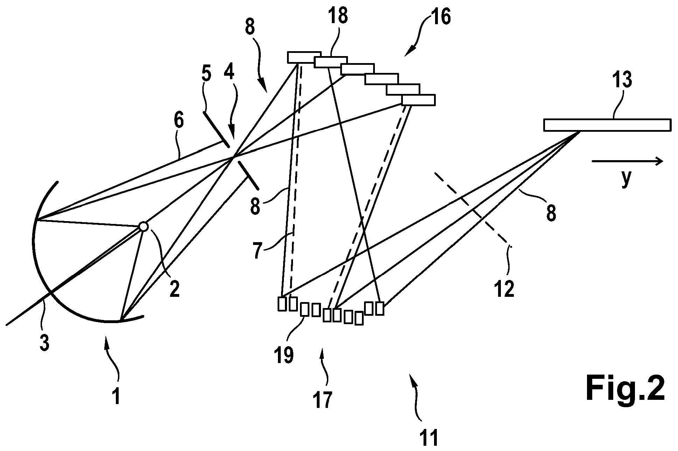

In Figur 2 ist eine Strahlungsquelle in Verbindung mit einem Beleuchtungssystem 11 dargestellt, das Teil einer Projektionsbelichtungsvorrichtung für die EUV-Lithographie ist. Ein Kollektor 1 ist um eine Lichtquelle angeordnet, die von einem Plasmatröpfchen 2 gebildet wird, die von einem Infrarotlaser 3 angeregt wird. Um im EUV-Wellenlängenbereich Wellenlängen im Bereich um beispielsweise 13,5 nm zu erhalten, kann z.B. Zinn mittels eines bei einer Wellenlänge von 10,6 µm arbeitenden Kohlendioxidlasers zu einem Plasma angeregt werden. Anstelle eines Kohlendioxidlasers können beispielsweise auch Festkörperlaser eingesetzt werden. Auf den Kollektor 1 folgen nach der Blende 5 am Zwischenfokus 4 ein Feldfacettenspiegel 16 mit einzelnen Facetten 18 und ein Pupillenfacettenspiegel 17 mit einzelnen Facetten 19. Bevor die Strahlung auf das in y-Richtung abzuscannende Retikel 13 mit der auf einen Wafer zu projizierenden Struktur trifft, wird sie noch von einem Faltspiegel 12 umgelenkt. Der Faltspiegel 12 hat weniger optische Funktion, er dient vielmehr dazu, den Platzbedarf des Beleuchtungssystems 11 zu optimieren.

Es sei darauf hingewiesen, dass in der UV- oder EUV-Lithographie verschiedenste Strahlungsquellen eingesetzt werden können, u.a. Plasmaquellen, die etwa auf Laseranregung (LPP-Quellen) oder Gasentladung (DPP-Quellen) basieren können, Synchrotronstrahlungsquellen oder freie Elektronenlaser (FEL). Ferner können die Kollektoren beliebig ausgestaltet sein, u.a. auch als Wolter-Kollektor oder als ellipsoider Kollektor, bevorzugt angepasst an die jeweils verwendete Strahlungsquelle.

Die Facettenspiegel, insbesondere der Feldfacettenspiegel sind im vorliegenden Beispiel als reflektives optisches Element für den extrem ultravioletten Wellenlängenbereich, zusammengesetzt aus mindestens zwei Obereinheiten ausgebildet, wobei jede Obereinheit eine Vielzahl von Untereinheiten aufweist und wobei jede Obereinheit eine reflektive Beschichtung aufweist, die an die jeweils über die Fläche der Obereinheit im Betrieb auftretenden Einfallswinkel und Einfallswinkelbandbreiten angepasst ist. Der Feldfacettenspiegel wurde hergestellt, indem zunächst die über die Fläche jeder Obereinheit im Betrieb auftretenden Einfallswinkel und Einfallswinkelbandbreiten bestimmt wurden und anschließend eine reflektive Beschichtung auf jeder Obereinheit aufgebracht wurde, die an die jeweils über ihre Fläche bestimmten Einfallswinkel und Einfallswinkelbandbreiten angepasst ist.

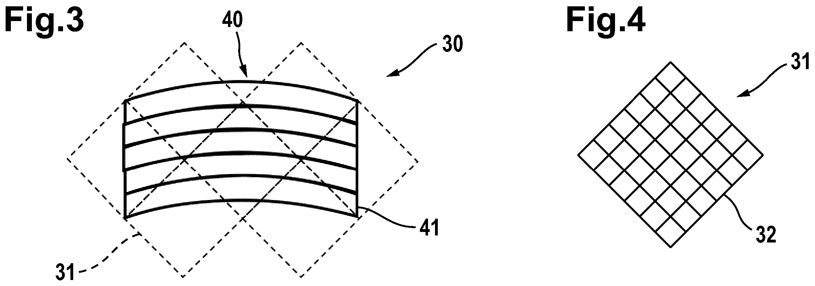

In Figur 3 ist ein erfindungsgemäßes reflektives optische Element 30 dargestellt, das fünf Obereinheiten 31 aufweist und ausgelegt ist, um einen herkömmlichen, nicht als Mikrospiegelarray ausgebildeten Feldfacettenspiegel 40 mit fünf Feldfacetten 41 zu ersetzen. Wie in Figur 4 exemplarisch dargestellt, weist eine Obereinheit 31 eine Vielzahl von Untereinheiten 32 auf, die im vorliegenden Beispiel als einzeln aktuierbare Mikrospiegel ausgebildet sind. Zusammen bilden sie ein mikroelektromechanisches System.

Wie in Figur 3 dargestellt ist, wird jede Feldfacette 41 durch mehrere Obereinheiten 31 gebildet und jede Obereinheit 31 trägt zu mehr als einer Feldfacette 41 bei. Jede Feldfacette 41 weist bedingt durch ihre verschiedenen Stellungen und ihre Krümmung einen individuellen Einfallswinkel sowie eine individuelle Einfallswinkelbandbreite auf. Somit treffen auch an unterschiedlichen Stellen jeder Obereinheit 31 verschiedene Einfallswinkel mit verschiedenen Einfallswinkelbandbreiten auf.

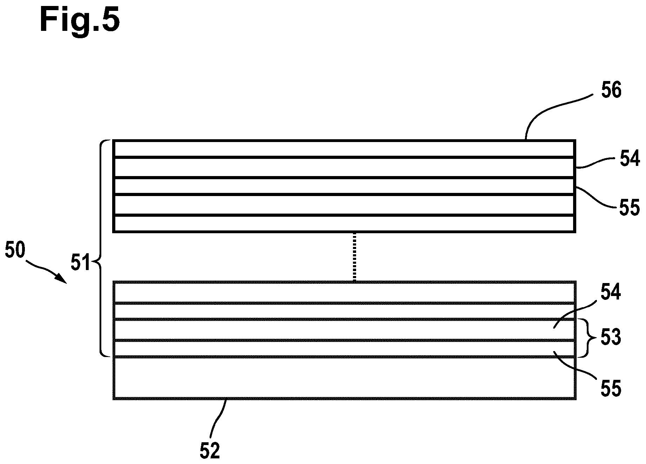

In Figur 5 ist schematisch die Struktur einer Untereinheit 50 des reflektiven optischen Elements dargestellt. Bei dem dargestellten Beispiel handelt es sich um ein Mikrospiegelelement, das auf einem auf einem Substrat 52 aufgebrachten Viellagensystem 51 basiert. Als Substratmaterialien werden bevorzugt Materialien mit geringem Wärmeausdehnungskoeffizienten gewählt. Bei dem Viellagensystem 51 handelt es sich im wesentlichen um alternierend aufgebrachte Lagen eines Materials mit höherem Realteil des Brechungsindex bei der Arbeitswellenlänge, bei der beispielsweise die lithographische Belichtung durchgeführt wird, (auch Spacer 55 genannt) und eines Materials mit niedrigerem Realteil des Brechungsindex bei der Arbeitswellenlänge (auch Absorber 54 genannt), wobei im hier dargestellten Beispiel ein Absorber-Spacer-Paar einen Stapel 53 bildet, der bei periodischen Viellagensystemen einer Periode entspricht. Dadurch wird in gewisser Weise ein Kristall simuliert, dessen Netzebenen den Absorberlagen entsprechen, an denen Bragg-Reflexion stattfindet. Die Dicken der einzelnen Lagen 54, 55 wie auch der sich wiederholenden Stapel 53 können über das gesamte Viellagensystem 51 konstant sein oder auch variieren, je nach dem, welches spektrale oder winkelabhängige Reflexionsprofil erreicht werden soll. Das Reflexionsprofil kann auch gezielt beeinflusst werden, indem die Grundstruktur aus Absorber 54 und Spacer 55 um weitere mehr und weniger absorbierende Materialien ergänzt wird, um die mögliche maximale Reflektivität bei der jeweiligen Arbeitswellenlänge zu erhöhen. Dazu können in manchen Stapeln Absorber- und/oder Spacer-Materialien gegeneinander ausgetauscht werden oder zusätzliche Lagen aus weiteren Materialien vorgesehen sein. Die Absorber- und Spacermaterialien können über alle Stapel konstante oder auch variierende Dicken aufweisen, um die Reflektivität zu optimieren. Ferner können in einzelnen oder allen Stapeln auch zusätzliche Lagen beispielsweise als Diffusionsbarrieren zwischen Spacer- und Absorberlagen 55, 54 vorgesehen werden, um die thermische Stabilität zu erhöhen. Bei der ersten an das Substrat 52 grenzenden Lage kann es sich um eine Absorber-, eine Spacer- oder auch eine zusätzliche Lage handeln. Zum Schutz der reflektiven Beschichtung vor äußeren Einflüssen kann abschließend zum Vakuum eine Schutzschicht 56 vorgesehen sein, die auch mehr als eine Lage aufweisen kann. Bevorzugte Materialien für den EUV-Wellenlängenbereich sind u.a. Molybdän als Absorbermaterial und Silizium als Spacermaterial.

Breitbandige reflektive Beschichtungen können auf übliche Weise durch Viellagensysteme erzeugt werden, die beispielsweise periodisch mit einer geringen Periodenanzahl sind, zwei oder mehr periodische Untersysteme mit unterschiedlicher Periodenlänge aufweisen oder komplett aperiodisch sind. Außerdem können sie einen Lagendickengradienten in Richtung senkrecht zum Substrat aufweisen. Der Einfallswinkel mit höchster Reflektivität für ein bestimmtes Viellagensystem kann beispielsweise verschoben werden, indem die Periodenlänge für dieses Viellagensystem verändert wird. Verschiedene Ansätze, wie man aus beispielsweise einem im Betrieb maximalen und einem im Betrieb minimalen Einfallswinkel auf ein reflektives optisches Element eine gewünschte Periodenlänge für dessen Viellagensystem als reflektiver Beschichtung bestimmt, ist zum Beispiel in der DE 2013 203 364 A1 beschrieben. Nachteilig ist bei der Wahl einer identischen reflektiven Beschichtung für alle Obereinheiten die vergleichsweise geringe Gesamtreflektivität.

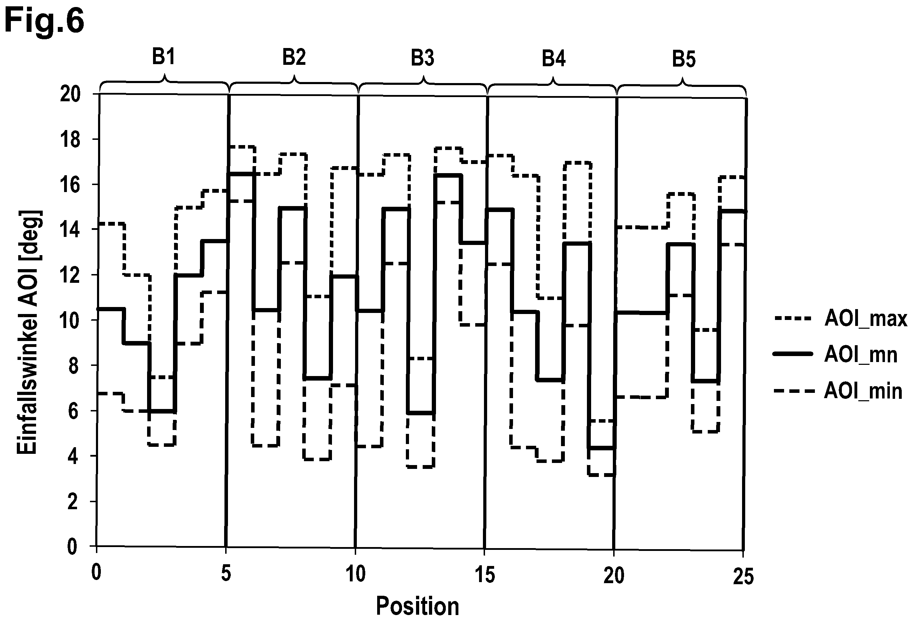

In Figur 6 sind beispielhaft die Einfallswinkel über die Fläche eines als Mikrospiegelarray ausgebildeten reflektiven optischen Elements dargestellt. Es weist exemplarisch fünf Obereinheiten B1 bis B5 auf, die als Unterarrays ausgebildet sind und als Untereinheiten eine Vielzahl von aktuierbaren Mikrospiegeln aufweisen. Im vorliegenden Beispiel dient das reflektive optische Element als Facettenspiegel, insbesondere als Feldfacettenspiegel, wobei jede Obereinheit abschnittsweise einer von fünf herkömmlichen Feldfacetten entspricht. In diesen Abschnitten treffen im Betrieb in beispielsweise dem Beleuchtungssystem einer EUV-Lithographievorrichtung auf jede Flächeneinheit einer Obereinheit B1 bis B5, die jeweils einer Feldfacette zugeordnet werden kann, unterschiedliche Einfallswinkelverteilungen auf. Davon sind für jede Obereinheit B1 bis B2 in Figur 6 als AOI_max maximaler Einfallswinkel (kurz gestrichelt) , AOI_mn mittlerer Einfallswinkel (durchgezogen) und AOI_min minimaler Einfallswinkel (lang gestrichelt) in Grad über verschiedene Positionen aufgetragen, die je einer Flächeneinheit bzw. einer Feldfacette zugeordnet sind. Über den Unterschied von minimalem und maximalem Einfallswinkel kann die jeweilige Einfallswinkelbandbreite ermittelt werden.

Im in Figur 6 dargestellten Beispiel schwanken in der ersten Obereinheit B1 die maximalen Einfallswinkel zwischen ca. 7,5° und ca. 15,5°, die minimalen Einfallswinkel zwischen ca. 4,5° und ca. 11,5° und die Einfallswinkelbandbreite zwischen ca. 2° und ca. 7°. Bei der zweiten Obereinheit B2 schwanken die maximalen Einfallswinkel zwischen ca. 11° und ca. 18°, die minimalen Einfallswinkel zwischen ca. 4° und ca. 12,5° und die Einfallswinkelbandbreite zwischen ca. 2° und ca. 8°. Bei der dritten Obereinheit B3 schwanken die maximalen Einfallswinkel zwischen ca. 8,5° und ca. 18°, die minimalen Einfallswinkel zwischen ca. 3,5° und ca. 15,5° und die Einfallswinkelbandbreite zwischen ca. 2° und ca. 7,5°. Bei der vierten Obereinheit B4 schwanken die maximalen Einfallswinkel zwischen ca. 5,5° und ca. 17,5°, die minimalen Einfallswinkel zwischen ca. 3,5° und ca. 13° und die Einfallswinkelbandbreite zwischen ca. 2° und ca. 8°. Bei der fünften Obereinheit B5 schwanken die maximalen Einfallswinkel zwischen ca. 9,5° und ca. 16,5°, die minimalen Einfallswinkel zwischen ca. 5° und ca. 13° und die Einfallswinkelbandbreite zwischen ca. 2° und ca. 5°.

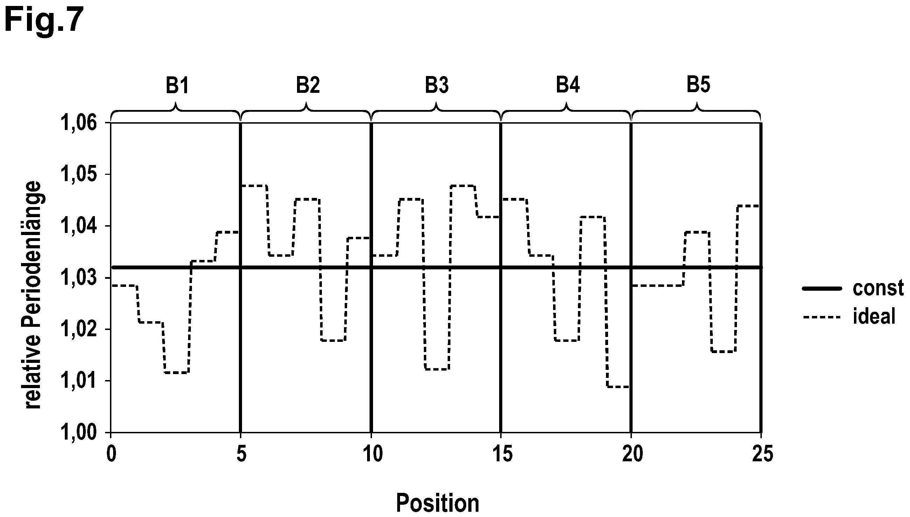

In Figur 7 ist ein aus fünf Obereinheiten B1 bis B5 zusammengesetztes reflektives optisches Element nach dem eingangs genannten Stand der Technik dargestellt. Es weist auf allen fünf Obereinheiten B1 bis B5 eine identische reflektive Beschichtung auf, die mit "const" bezeichnet ist. Außerdem ist die ideale gewünschte Periodenlänge über die einzelnen Positionen aufgetragen und mit "ideal" bezeichnet. Bei der reflektiven Beschichtung handelt es sich im vorliegenden Beispiel um ein periodisches Viellagensystem. Um die Reflektivität zu optimieren, wurde die Periodenlänge global über alle Obereinheiten B1 bis B5 um etwas mehr als 3% verlängert.

Um die Gesamtreflektivität des reflektiven optischen Elements, insbesondere beim Einsatz als Feldfacettenspiegel im Beleuchtungssystem einer EUV-Lithographievorrichtung, zu erhöhen, wird hier vorgeschlagen, bei der reflektiven Beschichtung der Obereinheiten die Einfallswinkel und Einfallswinkelverteilung, die beim Betrieb auftreten, für jede Obereinheit separat zu berücksichtigen. Vorteilhafterweise sind die reflektiven Beschichtungen als Viellagensystem ausgebildet, deren Lagendicken und/oder Lagenabfolge an die jeweils über die Fläche der Obereinheit im Betrieb auftretenden Einfallswinkel und Einfallswinkelbandbreiten angepasst sind. Insbesondere wird ausgenutzt, dass vor allem bei der Verwendung von Viellagensystemen als Basis der reflektiven Beschichtung, die für eine bestimmte Einfallswinkelbandbreite geeignet ist, durch Veränderung der Periodenlänge der Einfallswinkel mit der höchsten Reflektivität bei einer bestimmten Wellenlänge verändert werden kann.

In einem ersten Ausführungsbeispiel, welches nicht unter den beanspruchten Gegenstand fällt, ist die reflektive Beschichtung des reflektiven optischen Elements als Viellagensystem einer bestimmten Lagenabfolge ausgebildet, die auf einer für alle Obereinheiten gewünschten Breitbandigkeit beruht. Bevorzugt orientiert man sich in dieser Ausführungsform bei der gewünschten Breitbandigkeit an der Obereinheit mit der größten auftretenden Einfallswinkelbandbreite. Die gewünschte Periodenlänge ist für jede Obereinheit einzeln in Abhängigkeit der im Betrieb auftretenden Einfallswinkel optimiert. Auf diese Weise wird die Variation der gewünschten Periodenlänge über die Flächeneinheiten für jede Obereinheit durch ein Polynom 0-ten Grades angenähert und eine entsprechende reflektive Beschichtung aufgebracht.

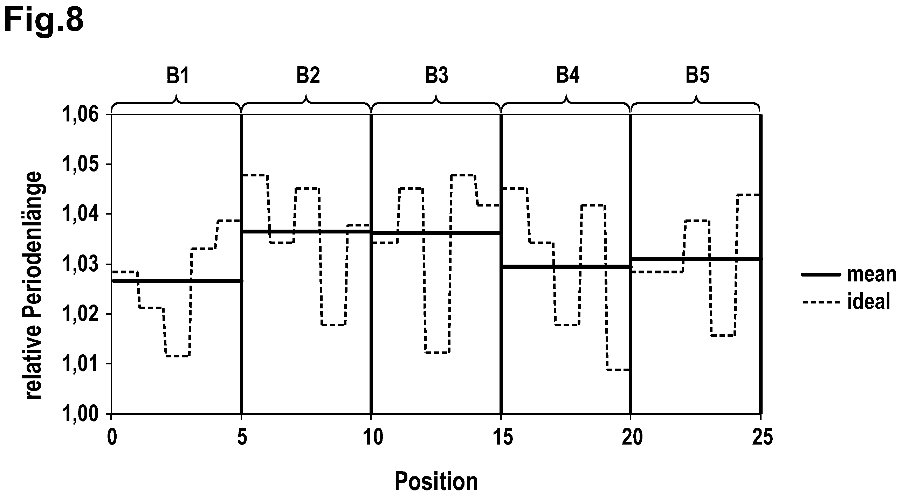

In Figur 8 ist eine solche Ausführungsform dargestellt, die analog zur Darstellung in Figur 7 ebenfalls fünf Obereinheiten B1 bis B5 aufweist und zur Verwendung als Feldfacettenspiegel mit den in Figur 6 dargestellten Einfallswinkeln ausgelegt ist. Für jede Obereinheit B1 bis B5 wurde für jede Flächeneinheit in Abhängigkeit von den dort auftretenden Einfallswinkeln die gewünschte Periodenlänge bestimmt. Entsprechend der für jede Obereinheit B1 bis B5 ermittelten Einfallswinkel und Einfallswinkelverteilung wurde berechnet, um welchen Faktor die gewünschte Periodenlänge des der reflektiven Beschichtung zugrundeliegenden Viellagensystems mit gewünschter Breitbandigkeit für jede Obereinheit modifiziert werden sollte. Im in Figur 8 dargestellten Beispiel schwankt der Faktor zwischen leicht unter 1,03 bis fast 1,04. Die Periodenlänge für die jeweilige Obereinheit ist als dicke durchgezogene Linie eingezeichnet, die mit "mean" bezeichnet ist.

Da die reflektive Beschichtung für alle Obereinheiten B1 bis B5 auf dem gleichen Viellagensystem mit gewünschter Breitbandigkeit basiert und somit sowohl die Materialien, ihre Abfolge als Lagen und die Lagendickenverhältnisse für alle Obereinheiten übereinstimmen, können alle fünf Obereinheiten als eine Charge beschichtet werden, wobei über den Beschichtungshalter eine unterschiedliche Schichtdickenverteilung eingestellt wird. Je nachdem, welche Obereinheit welche Periodenlänge aufweisen soll, werden sie für die Beschichtung entsprechend auf dem Beschichtungshalter angeordnet. Beispielsweise kann dafür ein um eine Achse rotierende Beschichtungshalter eingesetzt werden. Gebiete konstanter Schichtdicken liegen auf konzentrischen Kreisen um die Rotationsachse.

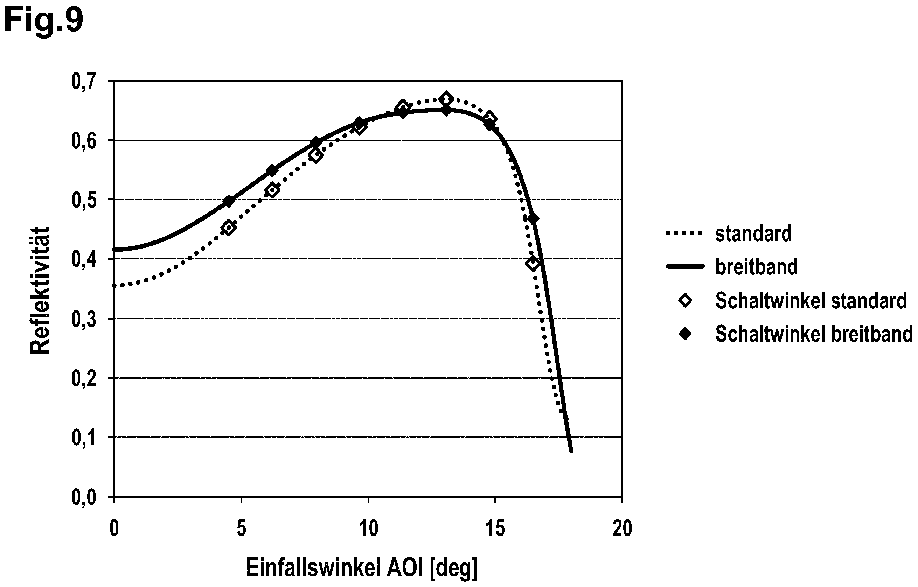

Gemäß dem beanspruchten Gegenstand werden je nach ermittelter Einfallswinkelbandbreite die Obereinheiten in verschiedene Klassen eingeteilt. Bei dem hier dargestellten Beispiel kann mit zwei Klassen gearbeitet werden. In der ersten Klasse sind die Obereinheiten B1 und B5 einsortiert, die eine Einfallswinkelbandbreite von ca. 12° aufweisen. In der zweiten Klasse sind die Obereinheiten B2, B3 und B4 einsortiert, die eine Einfallswinkelbandbreite von ca. 14° aufweisen (siehe Figur 6). Die Basisviellagensysteme werden für beide Klassen unterschiedlich und angepasst an die benötigte Bandbreite ausgewählt. Die Reflektivität in Abhängigkeit vom Einfallswinkel bei einer Wellenlänge von 13,5 nm ist in Figur 9 für beide Basisviellagensysteme dargestellt, als gepunktete Linie und mit "standard" bezeichnet für die erste Klasse und als durchgezogene Linie und mit "breitband" bezeichnet für die zweite Klasse. Die zwei Klassen können in zwei verschiedenen Chargen beschichtet werden. Man kann auch bei Variation eines rotationssymmetrischen Dickenverlaufs der Einzellagen, so dass sich ein Dickengradient senkrecht zum Substrat ergibt, Beschichtungen mit unterschiedlicher Breitbandigkeit auf verschiedenen Radien des Beschichtungshalters erhalten. Zusätzlich wird bei der Beschichtung jeder einzelnen Obereinheit auch die jeweils gewünschte Periodenlänge wie erläutert berücksichtigt.

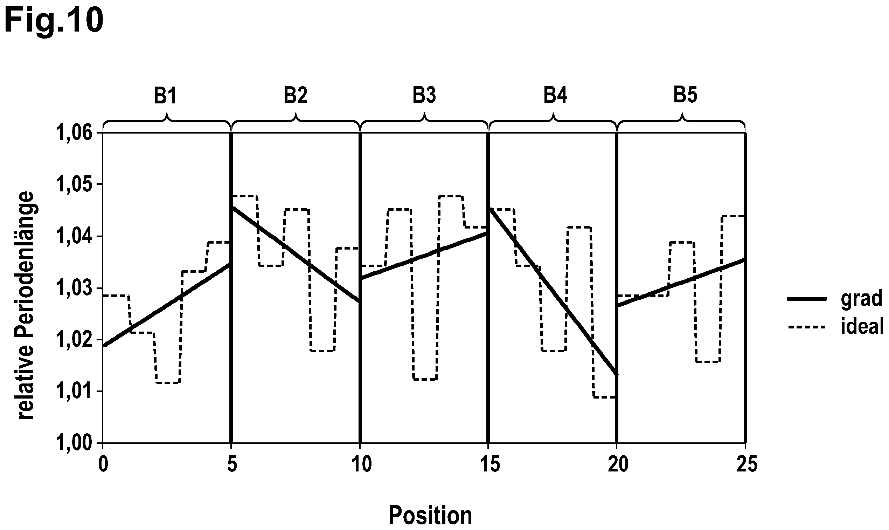

In einer weiteren, schematisch in Figur 10 dargestellten Ausführungsform sind beim reflektiven optischen Element die reflektiven Beschichtungen der Obereinheiten B1 bis B5 als Viellagensysteme ausgebildet, deren Lagendicken einem Polynom 1-ten Grades entspricht. Zur Herstellung dieser Ausführungsform wird jede Obereinheit in Flächeneinheiten aufgeteilt und werden für jede Obereinheit über alle ihre Flächeneinheiten die im Betrieb auftretenden Einfallswinkel bestimmt. Dann wird in Abhängigkeit der bestimmten Einfallswinkel eine gewünschte Periodenlänge eines Viellagensystems ermittelt, das die Variation der gewünschten Periodenlänge über die Flächeneinheiten für jede Obereinheit durch ein Polynom 1-ten Grades annähert. Anschließend wird auf jede Obereinheit das entsprechende Viellagensystem als reflektive Beschichtung aufgebracht. Im hier in Figur 10 dargestellten Beispiel wurde erneut jede Obereinheit B1 bis B5 in jeweils fünf Flächeneinheiten aufgeteilt und zwar wie auch in den anderen hier erläuterten Ausführungsbeispiele derart, dass jede Flächeneinheit zu einer anderen Feldfacette gehört und Untereinheiten, beispielsweise einzelne Mikrospiegel, mit ähnlichen Einfallswinkeln und Einfallswinkelbandbreiten zusammenfasst. Sie sind mit einer Position von 1 bis 25 bezeichnet. Die sich ergebende, durch eine Gerade angenäherte Periodenlänge für jede Obereinheit B1 bis B5 ist in Figur 9 als dicke durchgezogene Linie eingezeichnet und mit "grad" bezeichnet.

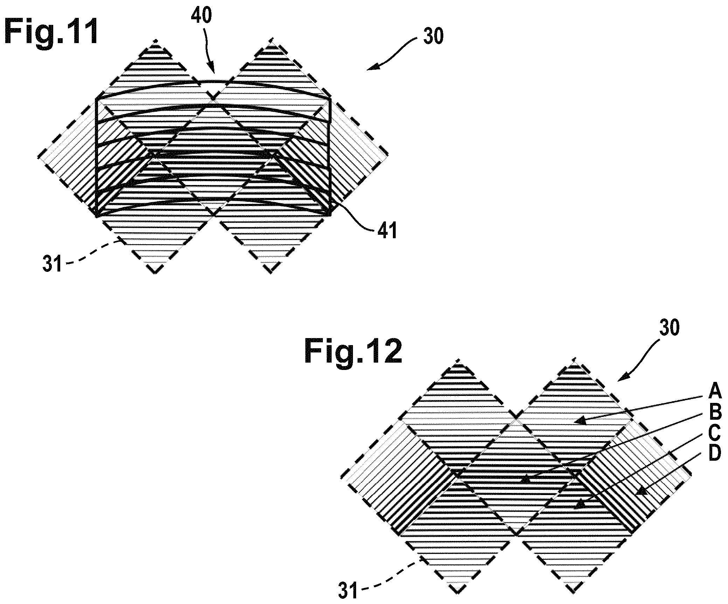

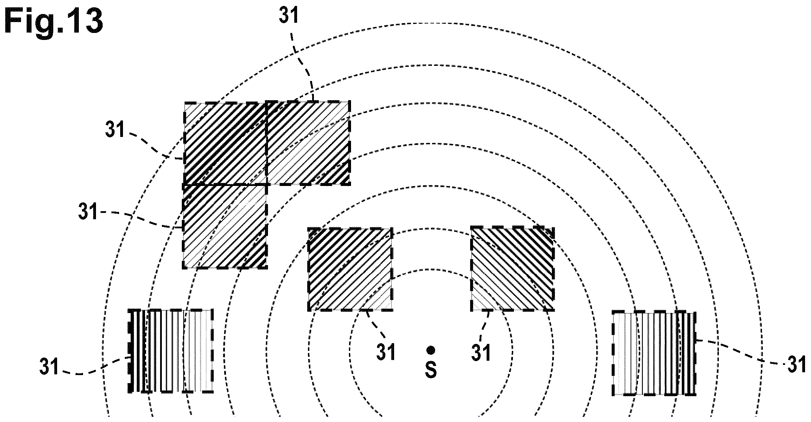

Die Annäherung der Variation des mittleren Einfallswinkels durch lineare Gradienten in möglichst wenige Richtungen erlaubt die Beschichtung aller Obereinheit in einer Charge. Dazu wird bei der Beschichtung ein Schichtdickenverlauf eingestellt, der über den Beschichtungshalter auf kurzer Ortswellenlänge oszilliert. In Figur 11 ist schematisch die Darstellung aus Figur 3 um die durch die Schraffur angedeutete Variation der Periodenlänge ergänzt. In Figur 12 sind die Feldfacetten weggelassen, um die Schraffur besser erkennen zu können. Dickere Linien deuten eine höhere Periodenlänge als dünnere Linien an. Im Bereich A benötigt man über die Diagonale der Obereinheit einen linearen Gradienten von maximaler zu minimaler zu maximaler Periodenlänge, im Bereich B ebenfalls über die Diagonale einen linearen Gradienten von minimaler zu maximaler zu minimaler Periodenlänge, im Bereich C ebenfalls über die Diagonale einen linearen Gradienten von maximaler zu minimaler Periodenlänge und im Bereich D in Längsrichtung einen linearen Gradienten von minimaler zu maximaler Periodenlänge. In einer Beschichtungsanlage, in der radialgeometrisch oszillierend Lagendicken aufgebracht werden können, können je nach benötigten Gradienten bei der Periodenlänge die zu beschichtenden Obereinheiten entsprechend auf dem Beschichtungshalter angeordnet werden, wie in Figur 13 schematische dargestellt ist, wobei die um die Spinachse S des Beschichtungshalters konzentrischen Kreise gestrichelte Linien konstanter Schichtdicke sind.

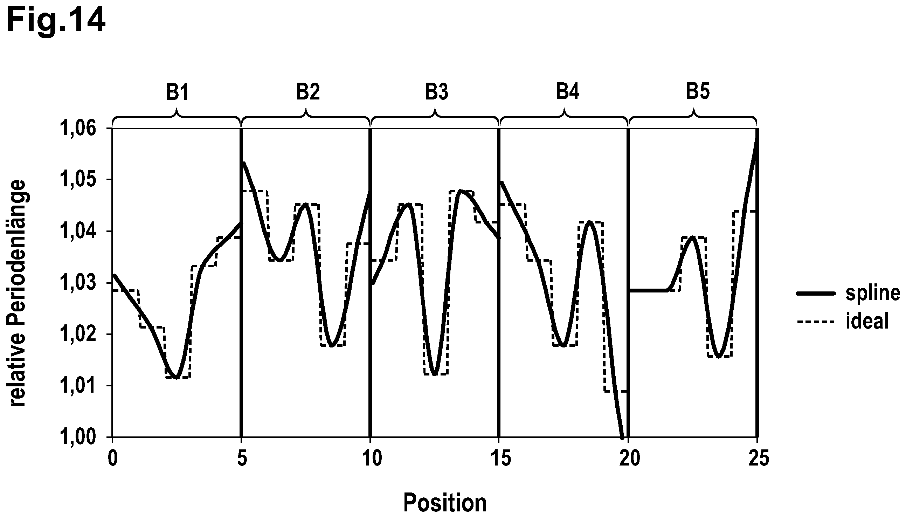

Im in Figur 14 dargestellten Beispiel wurde jede Obereinheit B1 bis B5 wie für die vorhergehenden Beispiele aufgeteilt. Allerdings wurde die Variation der idealen gewünschten Periodenlänge über die Flächeneinheiten für jede Obereinheit durch ein Polynom höheren Grades angenähert. Die sich daraus ergebende relative Periodenlänge des Basisviellagensystems für jede Obereinheit B1 bis B5 ist in Figur 13 als dicke durchgezogene Linie eingezeichnet und mit "spline" bezeichnet.

Bevorzugt wird diese Annäherung der Variation der mittleren Einfallswinkel für jede Obereinheit nicht nur in eine Richtung längs eines linearen Gradienten durchgeführt, sondern zweidimensional über die gesamte Fläche der jeweiligen Obereinheit. Eine entsprechende reflektive Beschichtung mit zweidimensionalen lokalen Dickenvariationen kann beispielsweise unter Verwendung von Wabenmasken hergestellt werden. Bei komplexeren Dickenverteilungen kann auch eine zeitliche steuerbare Methode ohne Maske wie etwa in DE 10 2012 205 615 A1 offenbart eingesetzt werden.

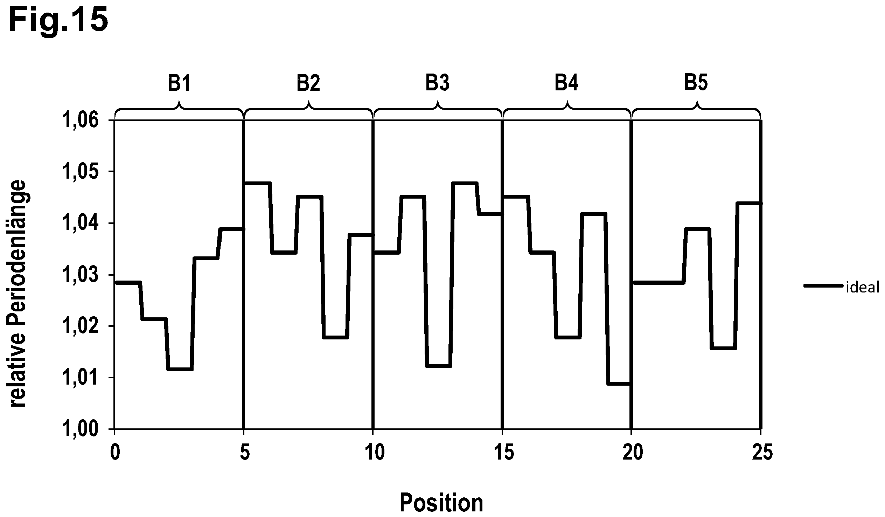

Je mehr Koeffizienten höheren Grades man berücksichtigt, desto besser kann der Verlauf der idealen gewünschten Periodenlänge angenähert werden. In Figur 15 ist schematisch ein Beispiel für einen Verlauf der Periodenlänge dargestellt, der mit dem Verlauf der idealen Periodenlänge übereinstimmt. Dieser Verlauf ist als dicke durchgezogene Linie eingezeichnet und mit "ideal" bezeichnet. Eine solche reflektive Beschichtung lässt sich insbesondere gut herstellen, wenn es sich bei den Untereinheiten jeder Obereinheit um einzeln aktuierbare Mikrospiegel handelt, wie etwa im Rahmen von mikroelektromechanischen Systemen. Da die aufgebrachte Beschichtungsdicke auch von der Orientierung der zu beschichtenden Fläche zur Teilchenquelle abhängt, kann jeder Mikrospiegel für die Beschichtung so verkippt werden, dass die tatsächlich deponierte Dicke der Solldicke entspricht. Insbesondere können dadurch die Unstetigkeiten in der idealen gewünschten Periodenlänge über die Fläche einer Obereinheit angenähert werden.

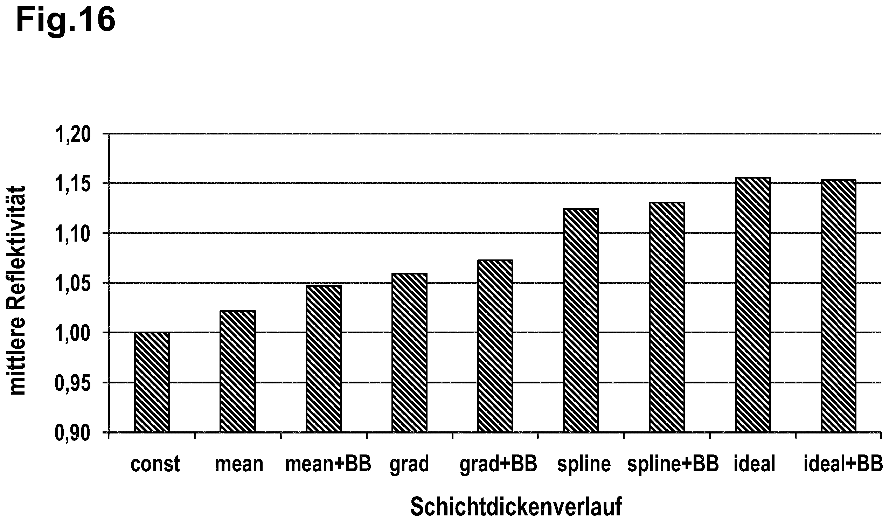

Anhand der folgenden Figuren 16 bis 19 soll der Effekt des hier vorgeschlagenen Vorgehens illustriert werden. In Figur 16 ist die mittlere Reflektivität über den gesamten Feldfacettenspiegel gerechnet für die hier vorgestellten Ausführungsbeispiele entsprechend den Figuren 8 ("mean"), 10 ("grad"), 14 ("spline") und 15 ("ideal") dargestellt. Dabei ist die Reflektivität auf den Wert des herkömmlichen reflektiven optischen Elements entsprechend Figur 7 normiert. Bereits durch Anpassen der reflektiven Beschichtung an den mittleren Einfallswinkel über jeder gesamte Obereinheit lässt sich ein deutlicher Reflektivitätsgewinn erreichen, mit der linearen Annäherung lässt die mittlere Reflektivität sich um über 5% steigern, mit der quadratischen Annäherung um etwa 12,5% und mit Anpassung an den mittleren Einfallswinkel jeder Feldfacette sogar um über 15%.

Ferner wurden auch Beispiele untersucht, bei denen zusätzlich, in Einklang mit dem beanspruchten Gegenstand, die Obereinheiten in zwei Breitbandigkeitsklassen eingeteilt wurden und die Obereinheiten B1 und B5 mit dem in Verbindung mit Figur 9 erläuterten Basisviellagensystem "standard" und die Obereinheiten B2 bis B4 mit dem Basisviellagensystem "breitband" versehen wurden. Die entsprechenden Werte sind in Figur 16 mit dem Zusatz "+BB" versehen. Insbesondere bei den Ausführungsformen "mean" und "grad" lässt sich durch die Berücksichtigung der Einfallswinkelbandbreiten eine zusätzliche Steigerung der Gesamtreflektivität um einige Prozent erreichen.

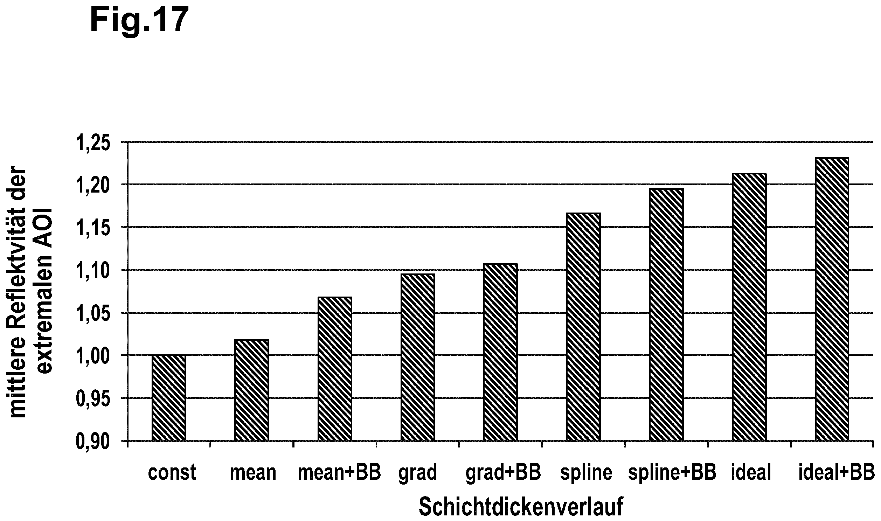

Diese Reflektivitätssteigerungen lassen sich in noch größerem Ausmaß für die mittlere Reflektivität bei den extremalen Einfallswinkeln, also den minimalen und maximalen Einfallswinkel feststellen (siehe Figur 17).

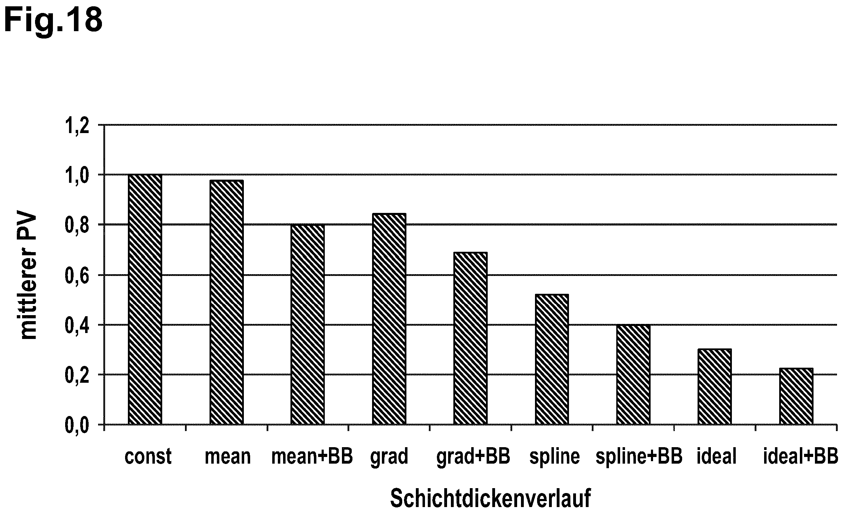

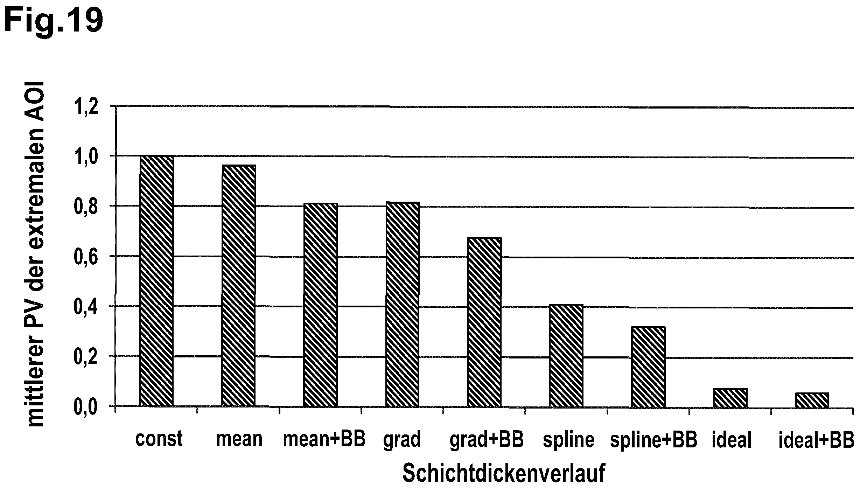

Es wurden auch die mittleren Peak-Valley-Werte für den mittleren (Figur 18) wie auch die extremalen Einfallswinkel (Figur 19) betrachtet, wobei der mittlere Peak-Valley-Wert ein Maß ist für die Abweichung der tatsächlichen Beschichtung von der idealen reflektiven Beschichtung, die an jedem Flächenpunkt auf die jeweiligen dort auftretenden Einfallswinkel optimiert ist. Die Peak-Valley-Werte sind wieder auf den Wert für das Beispiel 7 entsprechend dem Stand der Technik normiert. Insbesondere für die extremalen Einfallswinkel kann durch das hier erläuterte Vorgehen die Idealbeschichtung gut angenähert werden.

## Patentansprüche

1. Verfahren zur Herstellung eines aus mindestens zwei Obereinheiten (31) zusammengesetzten reflektiven optischen Elements (30) für den extrem ultravioletten Wellenlängenbereich, wobei jede Obereinheit (31) eine Vielzahl von Untereinheiten (32) aufweist, mit den Schritten:
- Bestimmen von über die Fläche jeder Obereinheit (31) im Betrieb auftretenden Einfallswinkeln und Einfallswinkelbandbreiten sowie der maximalen Bandbreite der Einfallswinkel;
- Aufteilen der Obereinheiten (31) in Bandbreitenklassen mit für die jeweilige Bandbreitenklasse bestimmte maximale Bandbreite;
- Aufbringen einer reflektiven Beschichtung (51) auf jeder Obereinheit (31), die an die jeweils über ihre Fläche bestimmten Einfallswinkel und Einfallswinkelbandbreiten angepasst ist, wobei auf alle Obereinheiten (31) als reflektive Beschichtung ein Viellagensystem (51) mit Periodenlänge aufgebracht wird, dessen Lagenabfolge und/oder Lagendicken an die für die jeweilige Bandbreitenklasse bestimmte maximale Bandbreite angepasst ist, wobei Basisviellagensysteme für jede Bandbreitenklasse unterschiedlich und an die benötigte Bandbreite ausgewählt werden und wobei die gewünschte Periodenlänge für jede Obereinheit (31) einzeln in Abhängigkeit der im Betrieb auftretenden Einfallswinkel optimiert wird, indem für jede Oberienheit innerhlab einer Bandbreitenklasse die Periodenlänge des Basisviellagensystems um einen Faktor modifiziert wird.

2. Verfahren nach Anspruch 1, **dadurch gekennzeichnet, dass** jede Obereinheit (31) in Flächeneinheiten aufgeteilt wird und für jede Obereinheit (31) über alle ihre Flächeneinheiten die im Betrieb auftretenden Einfallswinkel bestimmt werden, dass in Abhängigkeit der bestimmten Einfallswinkel eine gewünschte Periodenlänge eines Viellagensystems (51) ermittelt wird, das die Variation der gewünschten Periodenlänge über die Flächeneinheiten für jede Obereinheit (31) durch ein Polynom n-ten Grades, n eine nicht-negative ganze Zahl, annähert, und dass auf jede Obereinheit (31) das entsprechende Viellagensystem (51) als reflektive Beschichtung aufgebracht wird.

3. Verfahren nach Anspruch 2, **dadurch gekennzeichnet, dass** die Flächeneinheiten den Untereinheiten (32) entsprechen.

4. Verfahren nach einem der Ansprüche 1 bis 3, **dadurch gekennzeichnet, dass** auf die Obereinheiten (31) eine reflektive Beschichtung (51) aufgebracht wird, indem sie auf einen um eine Achse rotierenden Beschichtungshalter aufgebracht werden, wobei Gebiete konstanter Lagendicken konzentrisch um die Achse angeordnet sind.

5. Reflektives optisches Element für den extrem ultravioletten Wellenlängenbereich, hergestellt nach einem der Ansprüche 1 bis 4, welches Obereinheiten (31) aus mindestens zwei Bandbreitenklassen umfasst, wobei jede Bandbreitenklasse jeweils mindestens zwei Obereinheiten (31) umfasst.

6. Reflektives optisches Element nach Anspruch 5, **dadurch gekennzeichnet, dass** die reflektiven Beschichtungen als Viellagensysteme (51) ausgebildet sind, deren Lagendicken mit einer Funktion variiert, die jeweils einem Polynom n-ten Grades, n einer nicht-negativen ganzen Zahl, entspricht.

7. Reflektives optisches Element nach Anspruch 5 oder 6, **dadurch gekennzeichnet, dass** jede Untereinheit (32) als einzeln aktuierbarer Spiegel ausgebildet ist.

8. Reflektives optisches Element nach einem der Ansprüche 5 bis 7, **dadurch gekennzeichnet, dass** es als Feldfacettenspiegel (16, 114) ausgebildet ist.

9. Optisches System, insbesondere für die EUV-Lithographie, mit einem reflektiven optischen Element (16) nach einem der Ansprüche 5 bis 8.

10. EUV-Lithographievorrichtung mit einem reflektiven optischen Element (114) nach einem der Ansprüche 5 bis 8.

## Claims

1. Method for producing a reflective optical element (30), which is composed of at least two main units (31), for the extreme ultraviolet wavelength range, wherein each main unit (31) has a multiplicity of sub-units (32), having the steps of:
- determining angles of incidence and angle of incidence bandwidths occurring over the surface of each main unit (31) during operation, and also the maximum bandwidth of the angles of incidence;
- dividing the main units (31) into bandwidth classes with maximum bandwidth determined for the respective bandwidth class;
- applying a reflective coating (51) on each main unit (31), which is adapted to the angles of incidence and angle of incidence bandwidths which are respectively determined over the surface thereof, wherein a multilayer system (51) with period length is applied to all main units (31) as a reflective coating, the layer sequence and/or layer thicknesses of said multilayer system being adapted to the maximum bandwidth determined for the respective bandwidth class, wherein basic multilayer systems are selected differently for each bandwidth class and to the required bandwidth, and wherein the desired period length is optimized for each main unit (31) individually in dependence on the angles of incidence occurring during operation, by means of the period length of the basic multilayer system being modified by a factor for each main unit within a bandwidth class.

2. Method according to Claim 1, **characterized in that** each main unit (31) is divided into surface units, and for each main unit (31) the angles of incidence occurring during operation over all the surface units thereof are determined, **in that** a desired period length of a multilayer system (51) is ascertained in dependence on the determined angles of incidence, which multilayer system approximates the variation of the desired period length over the surface units for each main unit (31) by an nth-degree polynomial, with n being a non-negative integer, and **in that** the corresponding multilayer system (51) is applied to each main unit (31) as a reflective coating.

3. Method according to Claim 2, **characterized in that** the surface units correspond to the sub-units (32).

4. Method according to one of Claims 1 to 3, **characterized in that** a reflective coating (51) is applied to the main units (31) by locating them on a coating holder which rotates about an axis, wherein regions of constant layer thicknesses are arranged concentrically around the axis.

5. Reflective optical element for the extreme ultraviolet wavelength range, produced according to one of Claims 1 to 4, which comprises main units (31) from at least two bandwidth classes, wherein each bandwidth class comprises in each case at least two main units (31).

6. Reflective optical element according to Claim 5, **characterized in that** the reflective coatings are embodied as multilayer systems (51), the layer thicknesses of which vary with a function that corresponds in each case to an nth-degree polynomial, with n corresponding to a non-negative integer.

7. Reflective optical element according to Claim 5 or 6, **characterized in that** each sub-unit (32) is embodied as an individually actuable mirror.

8. Reflective optical element according to one of Claims 5 to 7, **characterized in that** it is embodied as a field facet mirror (16, 114).

9. Optical system, in particular for EUV lithography, having a reflective optical element (16) according to one of Claims 5 to 8.

10. EUV lithography apparatus having a reflective optical element (114) according to one of Claims 5 to 8.

## Revendications

1. Procédé de fabrication d'un élément optique réfléchissant (30) pour la gamme de longueurs d'onde ultraviolettes extrêmes, constitué d'au moins deux unités principales (31), chaque unité principale (31) comprenant une pluralité de sous-unités (32), le procédé comprenant les étapes consistant à :
- déterminer les angles d'incidence et les largeurs de bande d'angles d'incidence, ainsi que la largeur de bande maximale des angles d'incidence, apparaissant en cours de fonctionnement sur la surface de chaque unité principale (31) ;
- répartir les unités principales (31) en classes de largeur de bande avec une largeur de bande maximale déterminée pour la classe de largeur de bande respective ;
- appliquer sur chaque unité principale (31) un revêtement réfléchissant (51) qui est adapté aux angles d'incidence et aux largeurs de bande d'angles d'incidence déterminés sur leur surface respective, un système multicouche (51) présentant une certaine longueur de période étant appliqué sur toutes les unités principales (31) sous forme de revêtement réfléchissant, dont la séquence de couches et/ou les épaisseurs de couches sont adaptées à la largeur de bande maximale déterminée pour la classe de largeur de bande respective, les systèmes multicouches de base étant différents pour chaque classe de largeur de bande et étant sélectionnés en fonction de la largeur de bande requise, et la longueur de période souhaitée étant optimisée individuellement pour chaque unité principale (31) en fonction des angles d'incidence apparaissant en cours de fonctionnement, en modifiant la longueur de période du système multicouche de base d'un certain facteur pour chaque unité principale au sein d'une classe de largeur de bande.

2. Procédé selon la revendication 1, **caractérisé en ce que** chaque unité principale (31) est divisée en unités de surface et **en ce que**, pour chaque unité principale (31), les angles d'incidence apparaissant en cours de fonctionnement sont déterminés sur toutes ses unités de surface, **en ce qu'**une longueur de période souhaitée d'un système multicouche (51) est déterminée en fonction des angles d'incidence déterminés, lequel système détermine approximativement la variation de la longueur de période souhaitée sur les unités de surface pour chaque unité principale (31) par un polynôme de degré n, n étant un nombre entier non négatif, et **en ce que** le système multicouche (51) correspondant est appliqué sur chaque unité principale (31) sous forme de revêtement réfléchissant.

3. Procédé selon la revendication 2, **caractérisé en ce que** les unités de surface correspondent aux sous-unités (32).

4. Procédé selon l'une quelconque des revendications 1 à 3, **caractérisé en ce qu'**un revêtement réfléchissant (51) est appliqué sur les unités principales (31) en les plaçant sur un support de revêtement tournant autour d'un axe, des zones d'épaisseurs de couches constantes étant disposées de manière concentrique autour dudit axe.

5. Élément optique réfléchissant pour la gamme de longueurs d'onde ultraviolettes extrêmes, fabriqué selon l'une quelconque des revendications 1 à 4, qui comprend des unités principales (31) appartenant à au moins deux classes de largeur de bande, chaque classe de largeur de bande comprenant au moins deux unités principales (31).

6. Élément optique réfléchissant selon la revendication 5, **caractérisé en ce que** les revêtements réfléchissants sont réalisés sous forme de systèmes multicouches (51), dont les épaisseurs de couches varient conformément à une fonction qui correspond respectivement à un polynôme de degré n, n étant un nombre entier non négatif.

7. Élément optique réfléchissant selon la revendication 5 ou 6, **caractérisé en ce que** chaque sous-unité (32) est réalisée sous forme de miroir actionnable individuellement.

8. Élément optique réfléchissant selon l'une quelconque des revendications 5 à 7, **caractérisé en ce qu'**il est réalisé sous forme de miroir à facettes de champ (16, 114).

9. Système optique, en particulier pour la lithographie EUV, comprenant un élément optique réfléchissant (16) selon l'une quelconque des revendications 5 à 8.

10. Dispositif de lithographie EUV comprenant un élément optique réfléchissant (114) selon l'une quelconque des revendications 5 à 8.
